(19) Europäisches Patentamt

European Patent Office

Office européen des brevets

(11) EP 0 706 661 B1

(12) EUROPÄISCHE PATENTSCHRIFT

(45) Veröffentlichungstag und Bekanntmachung des Hinweises auf die Patenterteilung:
28.05.1997 Patentblatt 1997/22

(51) Int Cl.⁶: **G01R 15/24**

(21) Anmeldenummer: 94908957.7

(86) Internationale Anmeldenummer:
**PCT/DE94/00248**

(22) Anmeldetag: 10.03.1994

(87) Internationale Veröffentlichungsnummer:
**WO 94/24572 (27.10.1994 Gazette 1994/24)**

(54) **OPTISCHES MESSVERFAHREN ZUM MESSEN EINES ELEKTRISCHEN WECHSELSTROMES MIT TEMPERATURKOMPENSATION UND VORRICHTUNG ZUR DURCHFÜHRUNG DES VERFAHRENS**

OPTICAL METHOD OF MEASURING AN ALTERNATING ELECTRICAL CURRENT, INCLUDING TEMPERATURE COMPENSATION, AND A DEVICE FOR CARRYING OUT THE METHOD

PROCEDE OPTIQUE PERMETTANT DE MESURER UN COURANT ALTERNATIF ELECTRIQUE COMPENSE EN TEMPERATURE ET DISPOSITIF DE MISE EN OUVRE DUDIT PROCEDE

(84) Benannte Vertragsstaaten:
**CH DE FR LI SE**

(30) Priorität: **14.04.1993 DE 4312184**

(43) Veröffentlichungstag der Anmeldung:
**17.04.1996 Patentblatt 1996/16**

(73) Patentinhaber: **SIEMENS AKTIENGESELLSCHAFT
80333 München (DE)**

(72) Erfinder: **BOSSELMANN, Thomas
D-91054 Erlangen (DE)**

(56) Entgegenhaltungen:
**EP-A- 0 088 419        EP-A- 0 557 090
WO-A-91/01501        US-A- 4 755 665
US-A- 4 973 899**

## Beschreibung

Die Erfindung betrifft ein Verfahren zum Messen eines elektrischen Wechselstromes in einem Stromleiter gemäß dem Oberbegriff des Anspruchs 1, das beispielsweise aus US 4 755 665 oder aus US-A-4 973 899 bekannt ist, und eine entsprechende Vorrichtung gemäß dem Oberbegriff des Anspruchs 7.

Es sind optische Meßvorrichtungen zum Messen eines elektrischen Stromes in einem Stromleiter unter Ausnutzung des Faraday-Effekts bekannt, die auch als magnetooptische Stromwandler bezeichnet werden. Unter dem Faraday-Effekt versteht man die Drehung der Polarisationsebene von linear polarisiertem Licht in Abhängigkeit von einem Magnetfeld. Der Drehwinkel ist dabei proportional zum Wegintegral über dem magnetischen Feld entlang des von dem Licht zurückgelegten Weges mit der Verdet-Konstanten als Proportionalitätskonstanten. Die Verdet-Konstante ist abhängig von dem Material, in dem das Licht verläuft, von dessen Temperatur und von der Wellenlänge des Lichts. Zum Messen des Stromes ist ein Faraday-Element in der Nähe des Stromleiters angeordnet, das aus einem optisch transparenten, den Faraday-Effekt aufweisenden Material und im allgemeinen aus Glas besteht.

Durch das Faraday-Element wird von einer Sendeeinheit linear polarisiertes Licht geschickt. Das von dem elektrischen Strom erzeugte Magnetfeld bewirkt eine Drehung der Polarisationsebene des Lichtes in dem Faraday-Element um einen Polarisationsdrehwinkel, die von einer Auswerteeinheit als Maß für die Stärke des Magnetfeldes und damit für die Stärke des elektrischen Stromes ausgewertet werden kann. Im allgemeinen umgibt das Faraday-Element den Stromleiter, so daß das polarisierte Licht den Stromleiter in einem quasi geschlossenen Weg umläuft. Dadurch ist der Betrag des Polarisationsdrehwinkels in guter Näherung direkt proportional zur Amplitude des Meßstromes.

In einer bekannten Ausführungsform ist das Faraday-Element als massiver Glasring um den Stromleiter ausgebildet. Das Licht umläuft den Stromleiter in dieser Ausführungsform einmal (EP-B1-0 088 419).

In einer anderen bekannten Ausführungsform ist das Faraday-Element als Teil einer optischen Monomode-Faser ausgebildet, die den Stromleiter in Form einer Meßwicklung umgibt. Das Licht umläuft den Stromleiter daher bei einem Durchlauf N-mal, wenn N die Anzahl der Windungen der Meßwicklung ist. Es sind zwei Typen von solchen magnetooptischen Stromwandlern mit einer Meßwicklung einer Lichtfaser bekannt, nämlich der Transmissionstyp und der Reflexionstyp. Beim Transmissionstyp wird das Licht in ein Ende der Faser eingekoppelt und am anderen Ende wieder ausgekoppelt, so daß das Licht die Meßwicklung nur einmal durchläuft. Beim Reflexionstyp ist dagegen das andere Ende der Faser verspiegelt, so daß das an dem ersten Ende angekoppelte Licht an diesem anderen, verspiegelten Ende reflektiert wird, die Meßwicklung ein zweites Mal in umgekehrter Richtung durchläuft und am ersten Ende wieder ausgekoppelt wird. Wegen der Nicht-Reziprozität des Faraday-Effekts wird die Polarisationsebene des Lichts beim umgekehrten Durchlauf nochmal um den gleichen Betrag in die gleiche Richtung gedreht. Der Drehwinkel ist somit bei gleicher Meßwicklung doppelt so groß wie beim Transmissionstyp. Zur Trennung des eingekoppelten und des ausgekoppelten Lichts ist ein Strahlteiler vorgesehen (WO 91/01501).

Es sind ferner Verfahren zum Auswerten der Information, die in der gedrehten Polarisationsebene des Meßlichts über den Meßstrom enthalten ist, und entsprechende Vorrichtungen zur Durchführung dieser Verfahren bekannt, bei denen prinzipiell alle bekannten Ausführungsformen von Faraday-Elementen vorgesehen sein können.

Ein Problem bei allen magnetooptischen Stromwandlern sind Störeinflüsse durch lineare Doppelbrechung in dem Faraday-Element und den optischen Übertragungsstrecken. Solche lineare Doppelbrechung kann durch mechanische Spannungen in dem Material, die beispielsweise durch Verbiegen oder Vibration und insbesondere durch Temperaturänderungen hervorgerufen werden können, verursacht werden.

Bei dem bereits genannten, aus der EP-B1-0 088 419 bekannten magnetooptischen Stromwandler wird mit einem Polarisator das Licht einer Lichtquelle linear polarisiert und dann in das Faraday-Element eingekoppelt. Das linear polarisierte Licht durchläuft das Faraday-Element und wird wieder ausgekoppelt. Das ausgekoppelte Licht wird mit einem Wollaston-Prisma als Analysator in zwei linear polarisierte Lichtsignale A und B mit senkrecht zueinander gerichteten Polarisationsebenen geteilt. Diese beiden Lichtsignale A und B werden über entsprechende optische Übertragungsfasern zu entsprechenden Lichtdetektoren übertragen und in entsprechende elektrische Signale PA und PB umgewandelt. Aus diesen beiden Signalen PA und PB wird in einer Recheneinheit ein Faraday-Drehwinkel als Meßsignal berechnet, der dem Quotienten (PA-PB/ PA+PB) aus der Differenz und der Summe der beiden Signale entspricht. Durch diese Quotientenbildung werden unterschiedliche Empfindlichkeiten der Lichtdetektoren und unterschiedliche Dämpfungsfaktoren für die Intensitäten der Lichtsignale A und B in den beiden Übertragungsfasern ausgeglichen. Temperatureinflüsse können damit jedoch nicht kompensiert werden.

Bei einem anderen bekannten Auswerteverfahren werden die beiden Signale PA und PB jeweils in einem Filter in ihre Gleichstromanteile PA(DC) bzw. PB(DC) und ihre Wechselstromanteile PA(AC) bzw. PB(AC) unterteilt. Aus dem Wechselstromanteil PA(AC) bzw. PB(AC) und dem Gleichstromanteil PA(DC) bzw. PB(DC) wird für jedes Signal PA und PB zum Ausgleich von variierenden Lichtintensitäten infolge von Übertragungs- und Empfindlichkeitsschwankungen der Quotient QA = PA(AC)/PA(DC) bzw. QB = PB(AC)/PB(DC) aus seinem Wechselstromanteil (PA(AC) bzw. PB(AC) und seinem Gleichstromanteil (PA(DC) bzw. PA(DC) gebildet. Aus jedem dieser beiden Quotienten QA und QB wird ein zeitlicher Mittelwert $\overline{QA}$ und $\overline{QB}$ gebildet, und aus diesen beiden Mittelwerten $\overline{QA}$ und $\overline{QB}$ wird schließlich ein Quotient Q = $\overline{QA}/\overline{QB}$ gebildet (US 4,755,665). Im Rahmen eines aus Proc. Conf. Opt. Fiber Sensors OFS 1988, New Orleans, Seiten 288 bis 291 bekannten Iterationsverfahrens wird durch Vergleich mit in einer Wertetabelle (Look-up-table) gespeicherten, geeichten Werten ein Korrekturfaktor K für den ermittelten Quotienten Q erhalten. Der um diesen Korrekturfaktor K korrigierte Quotient QxK wird als temperaturkompensierter Meßwert für den Meßstrom herangezogen. Mit diesem Verfahren kann die Temperaturempfindlichkeit des magnetooptischen Stromwandlers auf etwa 1/50 herabgesetzt werden. Jedoch ist dieses Iterationsverfahren recht aufwendig.

Aus US-A-4,973,899 ist eine Meßvorrichtung mit einem Faraday-Element bekannt, bei der linear polarisiertes Meßlicht nach Durchlaufen des Faradayelements in zwei Lichtteilstrahlen zerlegt wird und diese beiden Lichtteilsignale von jeweils einem Photodetektor jeweils in ein elektrisches Intensitätssignal umgewandelt werden. Es sind Mittel zum Bilden des Quotienten aus einem Wechselsignalanteil und einem Gleichsignalanteil für jedes Intensitätssignal vorgesehen. Mit diesen beiden Quotienten werden ein erstes Ausgangssignal als Maß für einen Wechselstrom und ein zweites Ausgangssignal für einen Gleichstrom abgeleitet.

Der Erfindung liegt nun die Aufgabe zugrunde, ein Verfahren und eine Vorrichtung zum Messen eines elektrischen Wechselstromes in einem Stromleiter unter Ausnutzung des Faraday-Effekts, bei dem Temperatureinflüsse auf das Meßsignal vermindert werden, anzugeben.

Diese Aufgabe wird gemäß der Erfindung gelöst mit den Merkmalen des Anspruchs 1 bzw. des Anspruchs 7.

Vorteilhafte Ausgestaltungen des Verfahrens und der Vorrichtung gemäß der Erfindung ergeben sich aus den Unteransprüchen.

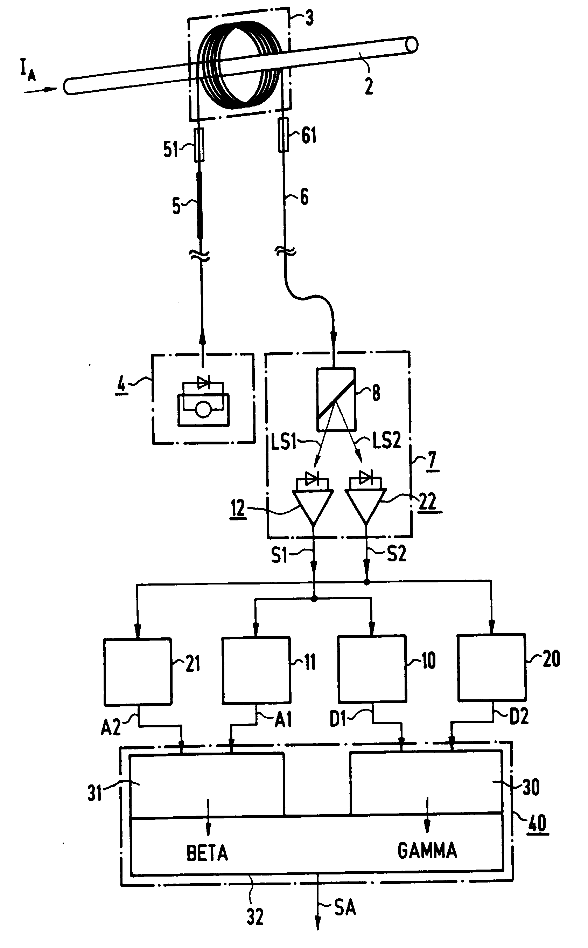

Zur weiteren Erläuterung der Erfindung wird auf die Zeichnung Bezug genommen, in deren einziger Figur ein Ausführungsbeispiel einer Vorrichtung schematisch dargestellt ist, mit der ein Verfahren zum Messen eines elektrischen Wechselstromes unter Ausnutzung des Faraday-Effekts gemäß der Erfindung durchgeführt werden kann.

Es sind ein Stromleiter mit 2, ein Faraday-Element mit 3 und eine Lichtquelle mit 4, ein Polarisator mit 5, ein Lichtwellenleiter mit 6, eine Wandlereinheit mit 7, zwei Tiefpaßfilter mit 10 und 20 und zwei Hochpaßfilter mit 11 und 21 sowie eine Auswerteeinheit mit 40 bezeichnet.

Über einen Eingang des Faraday-Elements 3 wird in dem Polarisator 5 linear polarisiertes Licht der Lichtquelle 4 in das Faraday-Element 3 eingekoppelt. Das linear polarisierte Licht kann auch von einer polarisierenden Lichtquelle wie beispielsweise einer Laserdiode erzeugt werden.

Das Faraday-Element 3 ist mit einem Ausgang über den polarisationserhaltenden Lichtwellenleiter 6, für den vorzugsweise eine Monomode-Lichtfaser vorgesehen ist, mit der Wandlereinheit 7 verbunden. Dämpfungsverluste in dem Lichtwellenleiter 6 spielen wegen seiner polarisationserhaltenden Eigenschaft praktisch keine Rolle. In der dargestellten Ausführungsform sind das Faraday-Element 3 selbst und die Übertragungsfaser zwischen Lichtquelle 4 und Faraday-Element 3 als Teile des Lichtwellenleiters 6 ausgebildet. Der Lichtwellenleiter 6 umgibt dabei vorzugsweise konzentrisch den Stromleiter 2 in einer Meßwicklung mit wenigstens einer Meßwindung, so daß sich eine entsprechende Ausführungsform vom Transmissionstyp ergibt. Es ist allerdings auch ein Stromwandler vom Reflexionstyp möglich. Außerdem kann als Faraday-Element 3 auch ein massiver Körper aus einem transparenten Material, vorzugsweise ein Glasring, vorgesehen sein. Vor den Eingang und hinter den Ausgang des Faraday-Elements 3 können jeweils ein Spleiß 51 bzw. 61 als lösbare Verbindungen geschaltet sein. In der Wandlereinheit 7 wird das aus dem Faraday-Element 3 ausgekoppelte Licht mit aufgrund des Faraday-Effekts um einen Meßwinkel ALPHA gedrehter Polarisation in zwei linear polarisierte Lichtsignale LS1 und LS2 mit unterschiedlichen und vorzugsweise senkrecht zueinander gerichteten Polarisationsebenen aufgespalten. Dazu ist vorzugsweise ein Wollaston-Prisma als strahlteilender Analysator 8 vorgesehen. Es können für die Funktion des strahl teilenden Analysators 8 allerdings auch zwei um einen entsprechenden Winkel und vorzugsweise um 90° gekreuzte Polarisationsfilter und ein Strahlteiler vorgesehen sein. Die beiden Lichtsignale LS1 und LS2 werden dann in zugeordneten optoelektrischen Wandlern 12 bzw. 22, für die vorzugsweise in Verstärkerkreise geschaltete Empfangs-LEDs geschaltet sind, in elektrische Signale S1 bzw. S2 umgewandelt, die ein Maß für die Lichtintensitäten der jeweiligen Lichtsignale LS1 bzw. LS2 sind. An zwei Ausgängen der Wandlereinheit 7 stehen diese beiden elektrischen Signale S1 und S2 an.

Mit dem einen Ausgang der Wandlereinheit 7 für das Signal S1 sind nun ein Tiefpaßfilter 10 und ein Hochpaßfilter 11 und mit dem anderen Ausgang der Wandlereinheit 7 für das Signal S2 sind ein Tiefpaßfilter 20 und ein Hochpaßfilter 21 elektrisch verbunden. Die Tiefpaßfilter 10 und 20 filtern die Gleichsignalanteile (DC-Signale) D1 bzw. D2 und die Hochpaßfilter 11 und 21 die Wechselsignalanteile (AC-Signale) A1 bzw. A2 der Signale S1 bzw. S2 heraus. Die Wechselsignalanteile A1 und A2 können allerdings auch als Komplemente der Gleichsignalanteile D1 bzw. D2 durch Subtraktion der Gleichsignalanteile D1 bzw. D2 von den Signalen S1 bzw. S2 erhalten werden, da S1 = A1 + D1 und S2 = A2 + D2 gilt. Umgekehrt können natürlich auch erst die Wechselsignalanteile A1 und A2 herausgefiltert und dann die Gleichsignalanteile D1 = S1 - A1 und D2 = S2 - A2 durch Subtraktion der Wechselsignalanteile A1 bzw. A2 vom Gesamtsignal S1 bzw. S2 ermittelt werden.

Die beiden Gleichsignalanteile D1 und D2 werden einer Recheneinheit 30 und die beiden Wechselsignalanteile A1 und A2 einer Recheneinheit 31 zugeführt. In der Recheneinheit 31 wird aus den beiden Wechselsignalanteilen A1 und A2 ein Winkelwechselanteil BETA für den Meßwinkel ALPHA ermittelt, der noch temperaturabhängig ist und der ferner alle Informationen über den Wechselstrom $I_A$ in dem Stromleiter 2 enthält. In der Recheneinheit 30 wird aus den Gleichsignalanteilen D1 und D2 ein Winkelgleichanteil GAMMA berechnet. Dieser Winkelgleichanteil GAMMA ist nun ein eindeutiges Maß für die Temperatur in dem optischen System, d.h. dem Faraday-Element 3 und den Übertragungsstrecken. Mit dem Winkelgleichanteil GAMMA wird in einer mit den beiden Recheneinheiten 30 und 31 elektrisch verbundenen Korrektureinheit 32 eine Korrektur des Winkelwechselanteils BETA des Meßwinkels ALPHA durchgeführt, um die durch die temperaturabhängige lineare Doppelbrechung in dem Faraday-Element 3 und den Übertragungsstrecken bewirkte störende Arbeitspunkt-Drift zu kompensieren. Der korrigierte Winkelwechselanteil BETA entspricht dem temperaturkompensierten Meßsignal SA für den Meßstrom $I_A$, das an einem Ausgang der Korrektureinheit 32 abgegriffen werden kann. Die Recheneinheiten 30 und 31 und die Korrektureinheit 32 sind in der Auswerteeinheit 40 zusammengefaßt.

In einer Ausführungsform des Verfahrens werden in den Recheneinheiten 30 und 31 die Quotienten aus den Differenzen ihrer Eingangssignale und deren Summen und in einer anderen Ausführungsform aus einem der Eingangssignale und der Summe der Eingangssignale gebildet. Im ersten Fall ergibt sich der Winkelwechselanteil BETA aus dem Quotienten (A1-A2)/(A1+A2) mit den Wechselsignalanteilen A1 und A2 und der Winkelgleichanteil GAMMA aus dem Quotienten (D1-D2)/(D1+D2) mit den Gleichsignalanteilen D1 und D2. Im zweiten Fall ergibt sich beispielsweise der Winkelgleichanteil GAMMA aus dem Quotienten D1/(D1+D2) oder D2/(D1+D2) und der Winkelwechselanteil BETA aus A1/(A1+A2) oder A2/(A1+A2). Es können allerdings auch unterschiedliche Funktionen, beispielsweise Mischformen aus diesen beiden Ausführungsformen, in den Recheneinheiten 30 und 31 realisiert sein.

In einer vorteilhaften Ausführungsform wird zu dem Winkelgleichanteil GAMMA mit Hilfe einer vorab ermittelten Wertetabelle (Look-up-table) oder einer Eichkurve eine effektive Verdet-Konstante $V_{eff}$ ermittelt. Das Meßsignal SA ist dann proportional zum Produkt aus dem Winkelwechselanteil BETA und dem Kehrwert dieser effektiven Verdet-Konstanten $V_{eff}$. Das Meßsignal SA kann allerdings auch direkt aus dem Winkelwechselanteil BETA und dem Winkelgleichanteil GAMMA anhand einer theoretisch angenäherten oder experimentell ermittelten Eichkurve abgeleitet werden.

In allen Ausführungsformen wird ausgenutzt, daß durch die Bildung des Winkelgleichanteils GAMMA eindeutige Informationen über die Temperatur und die dadurch bedingte lineare Doppelbrechung erhalten werden und diese Informationen zur Temperaturkompensation des Arbeitspunktes und damit des Meßsignals verwendet werden können.

**Patentansprüche**

1. Verfahren zum Messen eines elektrischen Wechselstromes ($I_A$) in einem Stromleiter (2) mittels eines dem Stromleiter (2) zugeordneten Faraday-Elements (3), bei dem

     a) in das Faraday-Element (3) linear polarisiertes Licht eingekoppelt wird und die Polarisationsebene dieses linear polarisierten Lichts aufgrund des Faraday-Effekts um einen von dem Wechselstrom ($I_A$) abhängigen Meßwinkel (ALPHA) gedreht wird,
     b) das Licht mit der gedrehten Polarisationsebene aus dem Faraday-Element (3) ausgekoppelt und in zwei Lichtsignale (LS1 und LS2) mit unterschiedlichen Polarisationsebenen aufgeteilt wird,
     c) jedes der beiden Lichtsignale (LS1 und LS2) in jeweils ein elektrisches Signal (S1 bzw. S2) umgewandelt wird, das abhängig von der Intensität des jeweiligen Lichtsignals (LS1 bzw. LS2) ist,
     d) jedes der beiden elektrischen Signale (S1 und S2) in einen Gleichsignalanteil (D1 bzw. D2) und einen Wechselsignalanteil (A1 bzw. A2) zerlegt wird,

**dadurch gekennzeichnet,** daß

     e) aus den Gleichsignalanteilen (D1 und D2) der beiden elektrischen Signale (S1 und S2) ein Winkelgleichanteil (GAMMA) hergeleitet wird, der eindeutig von der Temperatur im Faraday-Element (3) und in den optischen Übertragungsstrecken des Lichts abhängt;
     f) aus den Wechselsignalanteilen (A1 und A2) der beiden elektrischen Signale (S1 bzw. S2) ein Winkelwechselanteil (BETA) hergeleitet wird, der von dem Wechselstrom ($I_A$) und noch von der Temperatur abhängt,
     g) mit dem Winkelwechselanteil (BETA) und dem Winkelgleichanteil (GAMMA) ein weitgehend temperaturunabhängiges Meßsignal (SA) für den Wechselstrom ($I_A$) ermittelt wird.

2. Verfahren nach Anspruch 1, **dadurch gekennzeichnet,** daß der Winkelgleichanteil (GAMMA) aus dem Quotienten ((D1-D2)/(D1+D2)) aus der Differenz (D1-D2) der Gleichsignalanteile (D1 und D2) des ersten und des zweiten elektrischen Signals (S1 bzw. S2) und der Summe (D1+D2) dieser beiden Gleichsignalanteile (D1 und D2) ermittelt wird.

3. Verfahren nach Anspruch 1, **dadurch gekennzeichnet,** daß der Winkelgleichanteil (GAMMA) aus dem Quotienten (D1/(D1+D2) oder D2/(D1+D2)) aus einem der Gleichsignalanteile (D1 oder D2) der beiden elektrischen Signale (S1 und S2) und der Summe (D1+D2) dieser beiden Gleichsignalanteile (D1+D2) ermittelt wird.

4. Verfahren nach einem der Ansprüche 1 bis 3, **dadurch gekennzeichnet,** daß der Winkelwechselanteil (BETA) aus dem Quotienten ((A1-A2)/(A1+A2)) aus der Differenz (A1-A2) der Wechselsignalanteile (A1 und A2) des ersten und des zweiten elektrischen Signals (S1 bzw. S2) und der Summe (A1+A2) dieser beiden Wechselsignalanteile (A1 und A2) ermittelt wird.

5. Verfahren nach einem der Ansprüche 1 bis 3, **dadurch gekennzeichnet,** daß der Winkelwechselanteil (BETA) aus dem Quotienten (A1/(A1+A2) oder A2/(A1+A2)) aus einem der Wechselsignalanteile (A1 oder A2) der beiden elektrischen Signale (S1 und S2) und der Summe (A1+A2) dieser beiden Wechselsignalanteile (A1 und A2) ermittelt wird.

6. Verfahren nach einem der vorhergehenden Ansprüche, **dadurch gekennzeichnet,** daß aus dem Winkelgleichanteil (GAMMA) eine effektive Verdet-Konstante ($V_{eff}$) hergeleitet wird.

7. Vorrichtung zum Messen eines elektrischen Wechselstromes ($I_A$) in einem Stromleiter (2) mit

   a) einem dem Stromleiter (2) zugeordneten Faraday-Element (3),
   b) Mitteln (4, 5) zum Einkoppeln linear polarisierten Lichts in das Faraday-Element (3),
   c) einem mit dem Faraday-Element (3) optisch verbundenen strahlteilenden Analysator (8) zum Aufteilen des aus dem Faraday-Element (3) ausgekoppelten linear polarisierten Lichts mit aufgrund des Faraday-Effekts um einen von dem Wechselstrom ($I_A$) abhängigen Meßwinkel (ALPHA) gedrehter Polarisationsebene in zwei Lichtsignale (LS1, LS2) mit unterschiedlichen Polarisationsebenen,
   d) jeweils einem optoelektrischen Wandler (12, 22) für jedes der beiden Lichtsignale (LS1, LS2), der das zugeordnete Lichtsignal (LS1, LS2) in ein elektrisches Signal (S1, S2) umwandelt, das abhängig von der Intensität des zugeordneten Lichtsignals (LS1, LS2) ist,
   e) Mitteln (10, 11, 20, 21) zum Zerlegen beider elektrischen Signale (S1, S2) in jeweils einen Wechselsignalanteil (A1, A2) und einen Gleichsignalanteil (D1, D2),

   **dadurch gekennzeichnet,** daß

   f) eine Auswerteeinheit (40) vorgesehen ist, die

      f1) aus den Gleichsignalanteilen (D1, D2) der beiden elektrischen Signale (S1, S2) einen Winkelgleichanteil (GAMMA) herleitet, der eindeutig von der Temperatur im Faraday-Element (3) und in den optischen Üertragungsstrecken für das Licht abhängt,
      f2) aus den Wechselsignalanteilen (A1, A2) der beiden elektrischen Signale (S1, S2) einen Winkelwechselanteil (BETA) herleitet, der von dem Wechselstrom ($I_A$) und noch von der Temperatur abhängt, und die
      f3) mit dem Winkelwechselanteil (BETA) und dem Winkelgleichanteil (GAMMA) ein weitgehend temperaturunabhängiges Meßsignal (SA) für den Wechselstrom ($I_A$) ermittelt.

8. Vorrichtung nach Anspruch 7, **dadurch gekennzeichnet,** daß das Faraday-Element (3) und der strahlteilende Analysator (8) über einen polarisationserhaltenden Lichtwellenleiter (6) optisch miteinander verbunden sind.

9. Vorrichtung nach Anspruch 7 oder 8, **dadurch gekennzeichnet,** daß die Mittel zum Zerlegen der elektrischen Signale (S1 und S2) in ihre Gleichsignalanteile (D1 bzw. D2) und ihre Wechselsignalanteile (A1 bzw. A2) Tiefpaßfilter (10 bzw. 20) und Hochpaßfilter (11 bzw. 21) umfassen.

## Claims

1. Method for measuring an alternating electrical current ($I_A$) in a current conductor (2) by means of a Faraday element (3) assigned to the current conductor (2), in which:

   a) linearly polarized light is coupled into the Faraday element (3), and the plane of polarization of this linearly polarized light is rotated on the basis of the Faraday effect through a measuring angle (ALPHA) that is dependent on the alternating current ($I_A$);
   b) the light with the rotated polarization plane is coupled out of the Faraday element (3) and is divided into two light signals (LS1 and LS2) having different planes of polarization;

c) each of the two light signals (LS1 and LS2) is converted into an electrical signal (S1 and S2, respectively) which is dependent upon the intensity of the corresponding light signal (LS1 and LS2, respectively);

d) each of the two electrical signals (S1 and S2) is divided into a direct-signal component (D1 and D2, respectively) and an alternating-signal component (A1 and A2, respectively),

characterized in that

e) an angular direct component (GAMMA), which is clearly dependent on the temperature in the Faraday element (3) and in the optical transmission links of the light, is derived from the direct-signal components (D1 and D2) of the two electrical signals (S1 and S2);

f) an angular alternating component (BETA), which is dependent on the alternating current ($I_A$) and also on the temperature, is derived from the alternating-signal components (A1 and A2) of the two electrical signals (S1 and S2, respectively);

g) with the angular alternating component (BETA) and the angular direct component (GAMMA), a substantially temperature-independent measuring signal (SA) is determined for the alternating current ($I_A$).

2. Method according to claim 1, characterized in that the angular direct component (GAMMA) is determined from the quotient ((D1-D2)/(D1+D2)) of the difference (D1-D2) of the direct-signal components (D1 and D2) of the first and of the second electrical signal (S1 and S2, respectively) and of the sum (D1+D2) of these two direct-signal components (D1 and D2).

3. Method according to claim 1, characterized in that the angular direct component (GAMMA) is determined from the quotient (D1/(D1+D2) or D2/(D1+D2)) of one of the direct-signal components (D1 or D2) of the two electrical signals (S1 and S2) and of the sum (D1+D2) of these two direct-signal components (D1+D2).

4. Method according to one of claims 1 to 3, characterized in that the angular direct component (BETA) is determined from the quotient ((A1-A2)/(A1+A2)) of the difference (A1-A2) of the alternating-signal components (A1 and A2) of the first and of the second electrical signal (S1 and S2, respectively) and of the sum (A1+A2) of these two alternating-signal components (A1 and A2).

5. Method according to one of claims 1 to 3, characterized in that the angular alternating component (BETA) is determined from the quotient (A1/(A1+A2) or A2/(A1+A2)) of one of the alternating-signal components (A1 or A2) of the two electrical signals (S1 and S2) and of the sum (A1+A2) of these two alternating-signal components (A1 and A2).

6. Method according to one of the preceding claims, characterized in that an effective Verdet constant ($V_{eff}$) is derived from the angular direct component (GAMMA).

7. Device for measuring an alternating electrical current ($I_A$) in a current conductor (2), having:

a) a Faraday element (3) assigned to the current conductor (2);

b) means (4, 5) for coupling linearly polarized light into the Faraday element (3);

c) a beam-splitting analyzer (8) optically connected to the Faraday element (3) for dividing the linearly polarized light which is coupled out of the Faraday element (3) and which has a plane of polarization that is rotated on the basis of the Faraday effect through a measuring angle (ALPHA) that is dependent on the alternating current ($I_A$), into two light signals (LS1, LS2) having different planes of polarization;

d) a respective optoelectrical receiver (12, 22) for each of the two light signals (LS1, LS2) which converts the assigned light signal (LS1, LS2) into an electrical signal (S1, S2) which is dependent upon the intensity of the assigned light signal (LS1, LS2);

e) means (10, 11, 20, 21) for dividing the two electrical signals (S1, S2) into an alternating-signal component (A1, A2) and a direct-signal component (D1, D2) in each case,

characterized in that

f) there is provided an evaluator unit (40) which:

f1) derives an angular direct component (GAMMA), which is clearly dependent on the temperature in the Faraday element (3) and in the optical transmission links for the light, from the direct-signal components (D1, D2) of the two electrical signals (S1, S2);

f2) derives an angular alternating component (BETA), which is dependent on the alternating current ($I_A$) and also on the temperature, from the alternating-signal components (A1, A2) of the two electrical signals (S1, S2), and

f3) with the angular alternating component (BETA) and the angular direct component (GAMMA), derives a substantially temperature-independent measuring signal (SA) for the alternating current ($I_A$).

8. Device according to claim 7, characterized in that the Faraday element (3) and the beam-splitting analyzer (8) are optically interconnected by way of a polarization-sustaining optical waveguide (6).

9. Device according to claim 7 or 8, characterized in that the means for dividing the electrical signals (S1 and S2) into their direct-signal components (D1 and D2, respectively) and their alternating-signal components (A1 and A2, respectively) comprise low-pass filters (10 and 20, respectively) and high-pass filters (11 and 21, respectively).

**Revendications**

1. Procédé de mesure d'un courant ($I_A$) électrique alternatif dans un conducteur (2) de courant au moyen d'un élément (3) produisant l'effet Faraday associé au conducteur (2) de courant, dans lequel

   a) on envoie dans l'élément (3) produisant l'effet Faraday de la lumière à polarisation linéaire, et, en raison de l'effet Faraday, le plan de polarisation de cette lumière à polarisation linéaire tourne d'un angle (ALPHA) de mesure dépendant du courant ($I_A$) électrique alternatif,
   b) on fait sortir de l'élément (3) produisant l'effet Faraday la lumière ayant une rotation du plan de polarisation de l'angle (ALPHA) de mesure et on la sépare en deux signaux (LS1 et LS2) lumineux ayant des plans de polarisation différents,
   c) on convertit les deux signaux (LS1 et LS2) lumineux chacun en un signal (S1, respectivement S2) électrique, qui dépend de l'intensité du signal (LS1, respectivement LS2) lumineux associé,
   d) on décompose chacun des deux signaux (S1 et S2) électriques en une composante (D1, respectivement D2) de signal continue et en une composante (A1, respectivement A2) de signal alternative,

   caractérisé en ce que

   e) on déduit des composantes (D1 et D2) de signal continues des deux signaux (S1 et S2) électriques une composante (GAMMA) d'angle continue qui dépend de manière univoque de la température dans l'élément (3) produisant l'effet Faraday et dans les voies de transmission optiques de la lumière;
   f) on déduit des composantes (A1 et A2) de signal alternatives des deux signaux (S1 et S2) électriques une composante (BETA) d'angle alternative, qui dépend de manière univoque du courant ($I_A$) alternatif et encore de la température,
   g) on détermine par la composante (BETA) d'angle alternative et la composante (GAMMA) d'angle continue un signal (SA) de mesure du courant ($I_A$) alternatif qui est dans une grande mesure indépendant de la température.

2. Procédé suivant la revendication 1, caractérisé en ce que l'on détermine la composante (GAMMA) d'angle continue à partir du quotient ((D1 - D2)/(D1+D2)) de la différence (D1-D2) des composantes (D1 et D2) de signal continues du premier et du deuxième signal (S1 et S2) électrique sur la somme (D1+D2) de ces deux composantes (D1 et D2) de signal continues.

3. Procédé suivant la revendication 1, caractérisé en ce que l'on détermine la composante (GAMMA) d'angle continue à partir du quotient (D1/(D1+D2) ou D2/(D1+D2)) de l'une des composantes (D1 et D2) de signal continues des deux signaux (S1 et S2) électriques sur la somme (D1+D2) de ces deux composantes (D1 et D2) de signal continues.

4. Procédé suivant l'une des revendications 1 à 3, caractérisé en ce que l'on détermine la composante (BETA) d'angle alternative à partir du quotient ((A1-A2)/(A1+A2)) de la différence (A1-A2) des composantes (A1 et A2) de signal alternatives du premier et du deuxième signal (S1 et S2) électrique sur la somme (A1+A2) de ces deux composantes (A1 et A2) de signal alternatives.

5. Procédé suivant l'une des revendications 1 à 3, caractérisé en ce que l'on détermine la composante (BETA) d'angle alternative à partir du quotient (A1/(A1+A2) ou A2/(A1+A2)) de l'une des composantes (A1 et A2) de signal alternatives des deux signaux (S1 et S2) électriques sur la somme (A1+A2) de ces deux composantes (A1 et A2) de signal alternatives.

6. Procédé suivant l'une des revendications précédentes, caractérisé en ce que l'on déduit de la composante (GAMMA) d'angle continue une constante ($V_{eff}$) de Verdet réelle.

7. Dispositif de mesure d'un courant ($I_A$) électrique alternatif dans un conducteur (2) de courant, comportant

   a) un élément (3) produisant l'effet Faraday associé au conducteur (2) de courant,
   b) des moyens (4, 5) pour envoyer de la lumière à polarisation linéaire dans l'élément (3) produisant l'effet Faraday,

c) un analyseur (8) séparateur de faisceau, couplé du point de vue optique avec l'élément (3) produisant l'effet Faraday, servant à séparer en deux signaux (LS1, LS2) lumineux ayant des plans de polarisation différents la lumière à polarisation linéaire sortant de l'élément (3) produisant l'effet Faraday et ayant, en raison de l'effet Faraday une rotation du plan de polarisation en fonction du courant $(I_A)$ électrique alternatif,

d) pour chacun des deux signaux (LS1, LS2) lumineux, un transducteur (12, 22) opto-électrique, qui convertit le signal (LS1, LS2) lumineux associé en un signal (S1, S2) électrique qui dépend de l'intensité du signal (LS1, LS2) lumineux associé,

e) des moyens (10, 11, 20, 21) pour décomposer les deux signaux (S1, S2) électriques en une composante (A1, A2) de signal alternative et en une composante (D1, D2) de signal continue,

caractérisé en ce que

f) il est prévu une unité (40) d'exploitation qui

f1) déduit des composantes (D1, D2) de signal continues des deux signaux (S1, S2) électriques une composante (GAMMA) d'angle continue, qui dépend de manière univoque de la température dans l'élément (3) produisant l'effet Faraday et dans les voies de transmission optiques de la lumière,

f2) déduit des composantes (A1, A2) de signal alternatives des deux signaux (S1, S2) électriques une composante (BETA) d'angle alternative qui dépend du courant $(I_A)$ alternatif et encore de la température, et

f3) détermine par la composante (BETA) d'angle alternative et la composante (GAMMA) d'angle continue un signal (SA) de mesure du courant $(I_A)$ alternatif, qui est dans une grande mesure indépendant de la température.

8. Dispositif suivant la revendication 7, caractérisé en ce que l'élément (3) produisant l'effet Faraday et l'analyseur (8) séparateur de faisceau sont reliés l'une à l'autre du point de vue optique par l'intermédiaire d'un guide (6) d'ondes lumineuses conservant la polarisation.

9. Dispositif suivant la revendication 7 ou 8, caractérisé en ce que les moyens pour décomposer les signaux (S1 et S2) électriques en leurs composantes (D1 et D2) de signal continues et en leurs composantes (A1 et A2) de signal alternatives comprennent des filtres (10 et 20) passe-bas et des filtres (11 et 21) passe-haut.